# EUROPEAN PATENT APPLICATION

(11) **EP 1 901 352 A1**
(43) Date of publication of application: **19.03.2008**
(21) Application number: 06019025.3
(22) Date of filing: 12.09.2006
(51) Int. Cl.: H01L 23/467, H05K 7/20

(54) **Heat sink device generating an ionic wind**

(71) Applicant: Neng Tyi Precision Industries Co., Ltd., Taipei Hsien Taiwan (CN)
(72) Inventor: Wei, Wen-Chen, Taipei Hsien Taiwan (CN)
(74) Representative: LOUIS, PÖHLAU, LOHRENTZ

(57) **Abstract**

A heat sink device has a metal body (10, 10a, 10b, 10c, 10d, 10e) connected with a voltage source, multiple sharp teeth (11, 11a, 11b, 11c, 11d, 11e) formed on one side of the metal body (10, 10a, 10b, 10c, 10d, 10e), and a metal grounded member (20, 20a, 20b, 20d, 20e) provided separately from the metal body. When the metal body (10, 10a, 10b, 10c, 10d, 10e) is electrified, the sharp teeth are in a strong electrical field to generate a corona phenomenon, and the air around the sharp teeth (11, 11a, 11b, 11c, 11d, 11e) is ionized. The ions having the same charge with the sharp teeth (11, 11a, 11b, 11c, 11d, 11e) will be rejected by the sharp teeth (11, 11a, 11b, 11c, 11d, 11e), and all moves to the metal grounded member (20, 20a, 20b, 20d, 20e), whereby an electric wind is generated to dissipate the heat.

## Description

### 1. Field of the Invention

The present invention relates to a heat sink device by an ionic wind, and particularly relates to a heat sink device generating an ionic wind based on point discharge principle to provide a heat dissipation effect.

### 2. Description of the Related Art

Household electrical appliance normally produces a lot heat when in use, the heat is transformed from electrical energy. However, most electrical appliance can not go through high temperature well, and the electrical appliances are probably damaged by repeating heat. A heat sink device is often equipped for the electrical appliance.

A conventional heat sink device has a metal heat conductor, which has multiple cooling fins. A fan is mounted on the cooling fins. The heat from the heat source is transmitted to the cooling fins, and is dissipated by the fan, or the heat is just dissipated by the natural convection.

However, the noise and the using life of the fan are still problems, and the natural convection device is too big.

Therefore, the invention provides a heat sink device by ionic wind to mitigate or obviate the aforementioned problems.

The main objective of the present invention is to provide s heat sink device having a metal body connected with a voltage source, multiple sharp teeth formed on the metal body and a metal grounded member mounted separately from the metal body and connected with the ground.

When the metal body is electrified, the sharp teeth are in a strong electrical field to generate a corona phenomenon, and the air around the sharp teeth is ionized. The ions having the same charge with the sharp teeth will be rejected by the sharp teeth, and moves to the metal grounded member, and an electric wind is formed, which is also called an ionic wind. The ionic wind is strong enough to bring the air from the metal body to the metal grounded member, whereby the heat of the metal body is efficiently dissipated, according to the air convection.

In this way, the heat sink device of this invention has a reduced size, and no additional parts are necessary to save the energy source.

Other objectives, advantages and novel features of the invention will become more apparent from the following detailed description when taken in conjunction with the accompanying drawings.

### IN THE DRAWINGS

Fig. 1 is a perspective view of a first embodiment of a heat sink device in accordance with the present invention;
Fig. 2 is a perspective view of a second embodiment of a heat sink device in accordance with the present invention;
Fig. 3 is a perspective view of a third embodiment of a heat sink device in accordance with the present invention;
Fig. 4 is a perspective view of a fourth embodiment of a heat sink device in accordance with the present invention;
Fig. 5 is a perspective view of a fifth embodiment of a heat sink device in accordance with the present invention;
Fig. 6 is a side view in partial section of a heat sink device in accordance with the present invention applied on LED lights.

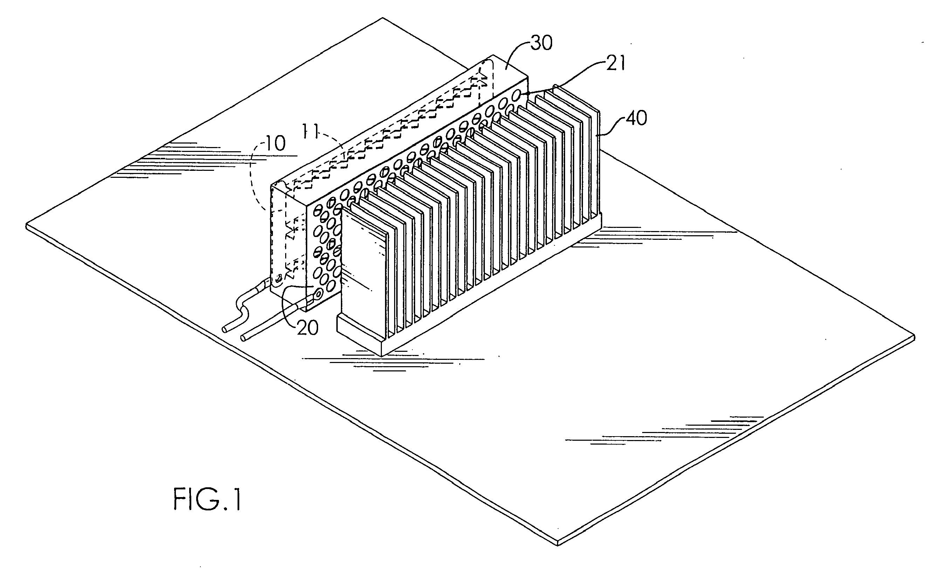

With reference to Fig. 1, a first embodiment of a heat sink device using for an ionic wind in accordance with the present invention has a metal body (10) connected with a voltage source. The metal body (10) is a vertical sheet and multiple sharp teeth (11) are formed on one side of the metal body (10).

A metal grounded member (20) is a vertical piece, is formed separately from the metal body (10), corresponds to the sharp teeth (11), and has multiple openings (21) having an amount same as that of the sharp teeth (11). Each opening (21) may be round or another shape.

An insulated frame (30) is mounted between the metal body (10) and the metal grounded body (20) to hold the metal body (10) and the metal grounded member (20) at a specified interval.

When the metal body (10) is electrified, the sharp teeth (11) are in a strong electrical field to form a corona phenomenon and the circumferential air around the sharp teeth (11) is ionized. The ions with an electric charge same as that on the sharp teeth (11) will be rejected by the sharp teeth (11), and all moves toward the metal grounded member (20). Consequently, an electric wind is formed, which is also called an ionic wind. The ionic wind is strong enough to bring the air from the metal body (10) to the metal grounded member (20).

In order to enhance the heat dissipation effect, multiple cooling fins (40) are provided behind the metal grounded member (20), which contacts with the heat source. The ionic wind will blow the heat away from the cooling fins (40), according to the air convection.

When the metal body (10) is electrified with positive voltage, the ionic wind is positive, and reversely, the ionic wind is negative.

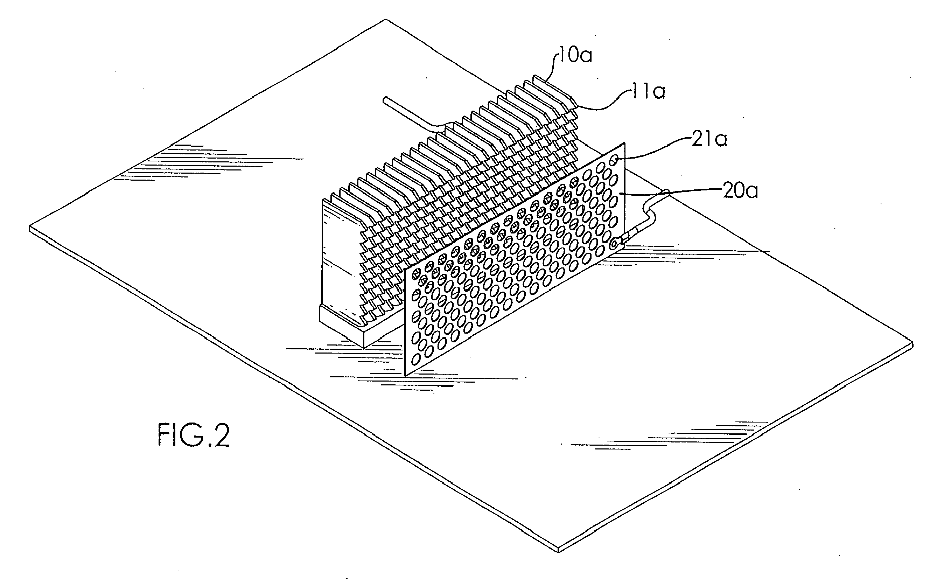

With reference to Fig. 2, a second embodiment in accordance with the present invention has a metal body (10a) that is a piece connected with the voltage source. Multiple sharp teeth (11 a) are formed on one side of the metal body (10a), and the metal body (10a) contacts with a heat source. A metal grounded member (20a) is mounted separately from the metal body (10a), corresponds to the sharp teeth (11a), and has multiple openings (2 1 a) having an amount same as that of the sharp teeth (11 a), and the opening (21a) is round or other shape.

When the metal body (10a) is electrified, the sharp teeth (11a) are in a strong electrical field to generate a corona phenomenon, and the circumferential air around the sharp teeth (11a) is ionized. The ions with an electric charge same as that on the sharp teeth (11a) will be rejected by the sharp teeth (11a), and all moves to the metal grounded member (20a), and an electric wind is formed, which is also called an ionic wind. The ionic wind is strong enough to bring the air from the metal body (10a) to the metal grounded member (20a), according to the air convection.

When the metal body (10a) is electrified with positive voltage, the ionic wind is positive, and reversely, the ionic wind is negative.

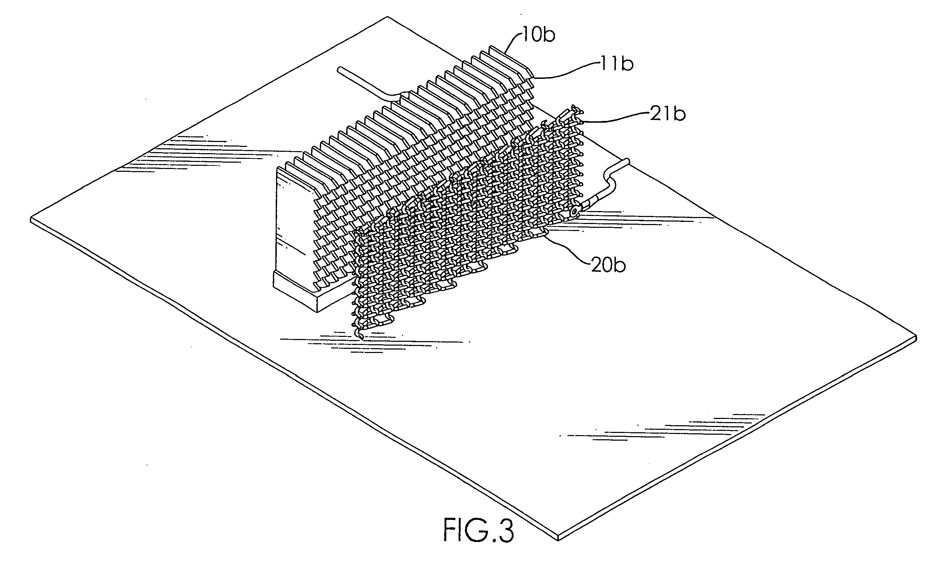

With reference to Fig. 3, a third embodiment in accordance with the present invention has a metal body (10b) that is a vertical piece connected with the voltage source, multiple sharp teeth (11b) are formed on one side of the metal body (10b), and the metal body (10b) contacts with a heat source.

A metal grounded member (20b) is provided separately from the metal body (10b), corresponds to the sharp teeth (11b), and has multiple openings (21b) having an amount same as that of the sharp teeth (11b).

When the metal body (10b) is electrified, the sharp teeth (11b) are in a strong electrical field to form a corona phenomenon, and the circumferential air around the sharp teeth (11b) is ionized. The ions with an electric charge same as that on the sharp teeth (11b) will be rejected by the sharp teeth (11b), and moves to the metal grounded member (20b), and an electric wind is formed, which is also called an ionic wind. The ionic wind is strong enough to bring the air from the metal body (10b) to the metal grounded member (20b), whereby the heat of the metal body (10b) is efficiently dissipated, according to the air convection.

When the metal body (10b) is electrified with positive voltage, the ionic wind is positive, and reversely, the ionic wind is negative.

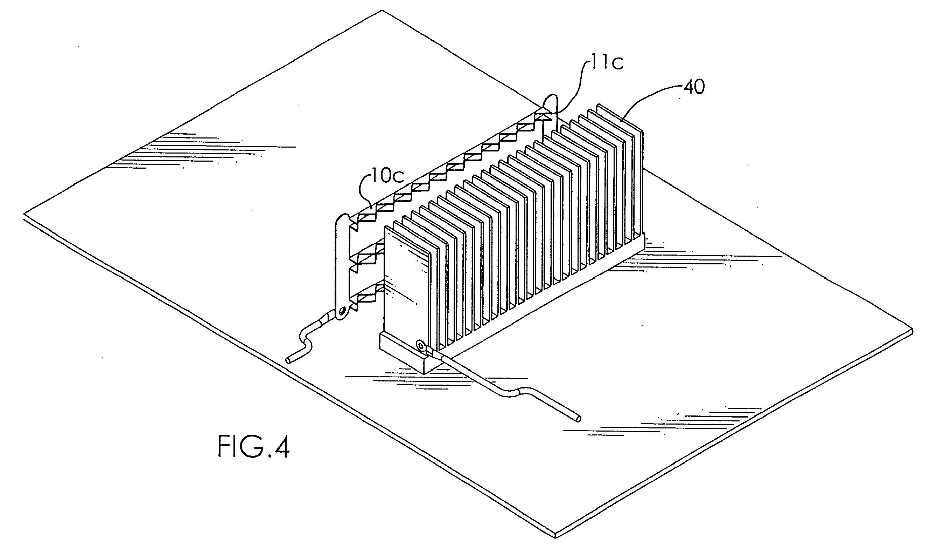

With reference to Fig. 4, a fourth embodiment of this invention has a metal body (10c) connected with the voltage source, multiple sharp teeth (11c) are formed thereon.

A metal grounded member (20c) comprises multiple vertical cooling fins and contacts with the heat source, and is provided separately from the metal body (10c). The number of the cooling fins is the same as the number of sharp teeth (11c).

When the metal body (10c) is electrified, the sharp teeth (11c) are in a strong electrical field to generate a corona phenomenon, and the air around the sharp teeth (11c) is ionized. The ions having the same charge with the sharp teeth (11c) will be rejected by the sharp teeth (11c), and moves to the metal grounded member (20c), and an electric wind is formed, which is also called an ionic wind. The ionic wind is strong enough to bring the air from the metal body (10c) to the metal grounded member (20c), whereby the heat of the metal grounded member (20c) is dissipated, according to the heat convection principle.

When the metal body (10c) is electrified with positive voltage, the ionic wind is positive, and reversely, the ionic wind is negative.

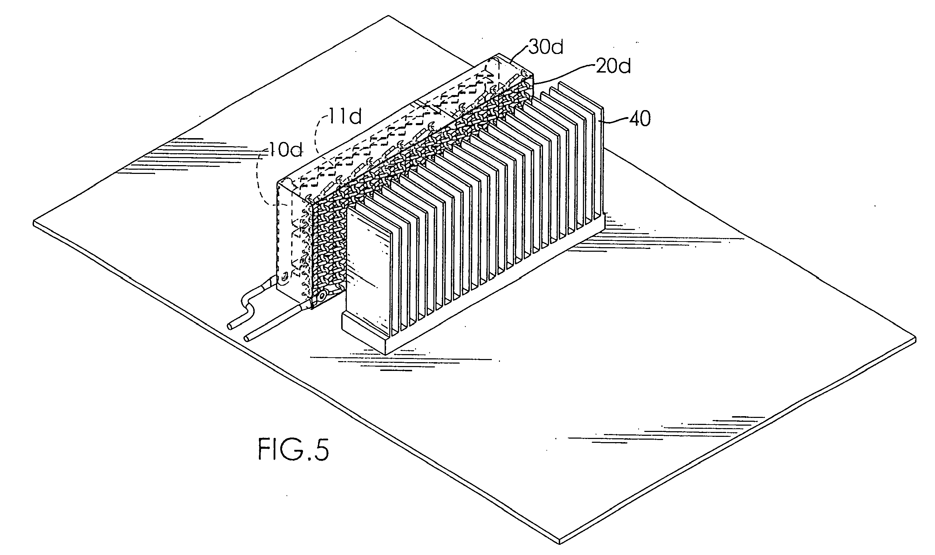

Fig. 5 shows a fifth embodiment of this invention, which is similar to the first embodiment, only the metal grounded member (20d) is a reticular piece, as shown in the third embodiment.

When the metal body (10d) is electrified, the sharp teeth (11d) are in a strong electrical field to cause a corona phenomenon, and the air around the sharp teeth (11d) is ionized. The ions having the same charge with the sharp teeth (11d) will be rejected by the sharp teeth (11d), and moves to the metal grounded member (20d), and an electric wind is formed, which is also called an ionic wind. The ionic wind is strong enough to bring the air from the metal body (10d) to the metal grounded member (20d), whereby the heat of the cooling fins (40) is efficiently dissipated, according to the heat convection principle.

When the metal body (10d) is electrified with positive voltage, the ionic wind is positive, and reversely, the ionic wind is negative.

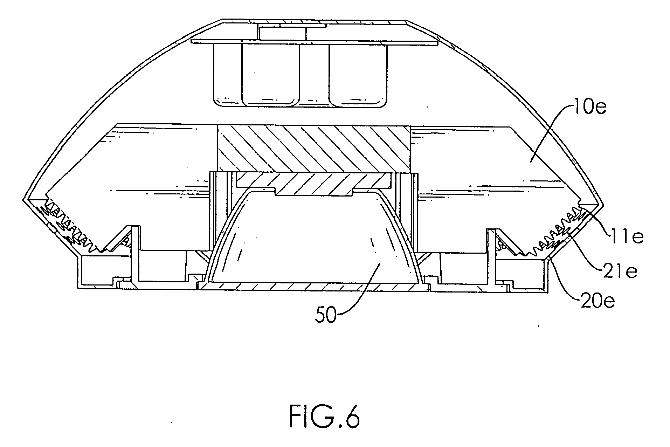

With reference to Fig. 6, a sixth embodiment shows the heat sink device of this invention applied on an LED light (50). The metal body (10e), which also comprises cooling fins and contacts with the heat source of the LED light (50). When the metal body (10e) is electrified, the sharp teeth (11e) are in a strong electrical field, and generate a corona phenomenon, and the air around the sharp teeth (11 e) is ionized. The ions having the same charge with the sharp teeth (11e) will be rejected by the sharp teeth (11e), and moves to the metal grounded member (20e), and an electric wind is formed. The ionic wind is strong enough to bring the air from the metal body (10e) to the metal grounded member (20e) according to the heat convection principle, so the heat generated by the LED light (50) is dissipated.

## Claims

1. A heat sink device comprising:
a metal body (10, 10a, 10b 10c, 10d, 10e) connected with a voltage source to electrify the metal body, and having multiple sharp teeth (11, 11a, 11b, 11c, 11d, 11e);
a metal grounded member (20, 20a, 20b, 20d, 20e) mounted separately from the metal body and corresponding to the sharp teeth (11, 11a, 11b, 11c, 11d, 11e) on the metal body to allow an ionic wind to be generated from the sharp teeth (11, 11 a) to the metal grounded member (20, 20a, 20b, 20d, 20e) when the metal body (10, 10a, 10b, 10c, 10d, 10e) is electrified.

2. The heat sink device by ionic wind as claimed in claim 1, wherein the metal body (10) is a vertical sheet, and the sharp teeth (11) are formed on one side of the sheet.

3. The heat sink device by ionic wind as claimed in claim 1, wherein the metal body (10a, 10b) is a vertical piece, and multiple sharp teeth (11 a, 11b) are formed on one side of the piece.

4. The heat sink device by ionic wind as claimed in claim 1, wherein the metal grounded member (20, 20a, 20b) is a vertical piece, and has multiple openings (21, 2 1 a, 21b) defined therein.

5. The heat sink device by ionic wind as claimed in claim 1, wherein the metal grounded member (20d) is a reticular piece.

6. The heat sink device by ionic wind as claimed in claim 1, wherein the metal grounded member (20d) comprises multiple cooling fins (40).

7. The heat sink device by ionic wind as claimed in claim 1, wherein multiple cooling fins (40) are provided separately from the metal grounded member (20d).

8. The heat sink device by ionic wind as claimed in claim 1, wherein:
an insulated frame (30) is mounted between the metal body (10) and the metal grounded member (20) to keep the metal body (10) and the metal grounded member (20) at an interval; and
multiple cooling fins (40) are provided separately from the metal grounded member (20d).

9. The heat sink device by ionic wind as claimed in claim 1, wherein the metal body (10) is a vertical piece, the sharp teeth (11) are formed in one side of the piece, the metal grounded member (20) is a vertical piece, and the metal grounded member (20) has multiple openings (21) defined therein.

10. The heat sink device by ionic wind as claimed in claim 1, wherein the metal body is a vertical piece (10d), the sharp teeth (11d) are formed in one side of the piece, and the metal grounded member (20d) is a reticular piece.
